# EUROPEAN PATENT APPLICATION

(11) **EP 1 923 913 A1**
(43) Date of publication of application: **21.05.2008**
(21) Application number: 06741912.7
(22) Date of filing: 18.05.2006
(51) Int. Cl.: H01L 23/34, H01L 23/02, H01L 21/50, H01L 25/00

(54) **INTEGRATED CIRCUIT PACKAGING AND METHOD OF MAKING THE SAME**

(30) Priority: 18.05.2005 CN 200510072950
(71) Applicant: NeoBulb Technologies, Inc., Bandar Seri Begawan (BN)
(72) Inventor: CHEN, Jen-Shyan, Hsinchu 30046 (TW)
(74) Representative: Becker, Bernd
(86) International application number: PCT/CN2006/001024
(87) International publication number: WO 2006/122505

(57) **Abstract**

The invention provides an integrated circuit packaging and method of making the same. The integrated circuit packaging includes a substrate, a semiconductor die, a heat-dissipating module, and a protection layer. The substrate has an inner circuit formed on a first surface, and an outer circuit formed on a second surface and electrically connected to the inner circuit. The semiconductor die is mounted on the first surface of the substrate such that the plurality of bond pads contact the inner circuit. The heat-dissipating module includes a heat-conducting device, and the heat-conducting device, via a flat end surface thereof, contacts and bonds with a back surface of the semiconductor die. The protection layer contacts a portion of the first surface of the substrate and a portion of the heat-conducting device, such that the semiconductor die is encapsulated therebetween.

## Description

### BACKGROUND OF THE INVENTION

### 1. Field of the invention

The present invention relates to an integrated circuit (IC) packaging structure and a method of making the same, and more particularly, the IC packaging structure according to the invention includes a heat-dissipating module.

### 2. Description of the prior art

Heat dissipating has always been a prerequisite consideration for the design of electronic systems to decrease the chances of a breakdown or destruction on an electric device caused by overheating, so as to improve the reliability of the whole system.

For current ICs, especially for CPU in computers, the technique for heat dissipation usually involves using a metal with high thermal conductivity as the basic heat-dissipating material and combining heat-dissipating fins and a powerful fan to fit the request of heat dissipating for the current ICs.

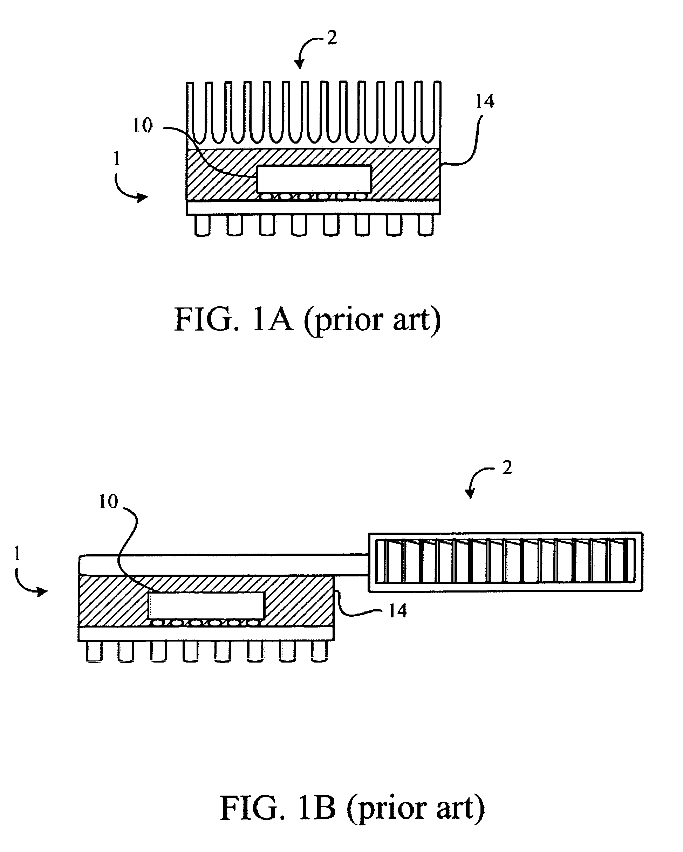

In the current heat-dissipating techniques, most of the heat-dissipating modules are configured on the casings of the packaged IC. Referring to FIG. 1A and FIG. 1B, FIG. 1A and FIG. 1B illustrate samples of current IC packaging structure configured with a heat-dissipating device. As shown in FIG. 1A and FIG. 1B, the heat produced by a chip 10 of an IC packaging structure 1 is conducted through a conducting layer 14 to a heat-dissipating module 2. Because the heat produced by the chip is dissipated by means of conducting through multilayer materials, not by means of directly contacting the heat dissipating module, the heat can not be quickly dissipated, and the problem of heat concentration caused by hot spots cannot be efficiently solved. Therefore, the heat-dissipating efficiency of a chip cannot be precisely controlled, and the performance of the IC is lowered due to overheating.

As the concept of mobile information arises, thin and small mobile products with high calculating performance are the mainstream. The technique for heat dissipating faces the challenge of products boasting characters of miniature, integration, high heat-dissipating capability, and high energy density. The current technique for heat dissipation is gradually failing to fulfill the demands of heat dissipation in new products. Especially for partial heat concentration of a chip, called hot spot issue, there is a need for new heat-dissipating techniques to solve these problems.

Accordingly, the invention provides an IC packaging structure therein integrated with a heat-dissipating module, which reduces the thermal resistance of the chip at the packaging stage to dissipate heat and effectively lower the temperature of the chip during operation. According to the invention, the IC packing structure can overcome the heat-dissipating problem and quickly conduct the heat produced by the chip to solve the hot spot issue.

### SUMMARY OF THE INVENTION

The present invention provides an IC packing structure and a method of making the same to achieve the above goal and solve the discussed issue.

According to a first preferred embodiment of the invention, the IC packing structure includes a substrate, a semiconductor die, a heat-dissipating module, and a protection layer. The substrate has a first surface, an inner circuit formed on the first surface, a second surface opposite to the first surface, and an outer circuit formed on the second surface. The outer circuit is electrically connected to the inner circuit. The semiconductor die has an active surface, a plurality of bond pads formed on the active surface, and a back surface opposite to the active surface. The semiconductor die is mounted on the first surface of the substrate, such that the plurality of bond pads contact the inner circuit. The heat-dissipating module includes a heat-conducting device which has a flat end surface. The heat-conducting device, via the flat end surface thereof, contacts and bonds with the back surface of the semiconductor die. The protection layer contacts a portion of the first surface of the substrate and a portion of the heat-conducting device, such that the semiconductor die is encapsulated therebetween.

According to the first preferred embodiment of the invention, the method of making the IC packing structure is to prepare a substrate, a semiconductor, and a heat-dissipating module. The substrate has a first surface, an inner circuit formed on the first surface, a second surface opposite to the first surface, and an outer circuit formed on the second surface. The outer circuit is electrically connected to the inner circuit. The semiconductor die has an active surface, a plurality of bond pads formed on the active surface, and a back surface opposite to the active surface. The heat-dissipating module includes a heat-conducting device which has a flat end surface at a distal end thereof.

The method is, first, to mount the semiconductor die on the first surface of the substrate, such that the plurality of bond pads contact the inner circuit. In the method, a protection layer is also formed to contact a portion of the substrate. The protection layer has an opening adapted to accommodate the flat end surface of the heat-conducting device. Furthermore, the distal end of the heat-conducting device is disposed into the opening of the protection layer, so the flat end surface of the heat-conducting device contacts and bonds with the back surface of the semiconductor die to complete the IC packing structure.

According to a second preferred embodiment of the invention, an IC packing structure includes a substrate, a protection layer, a semiconductor die, and a heat-dissipating module. The substrate has a first surface, an inner circuit formed on the first surface, a second surface opposite to the first surface, and an outer circuit formed on the second surface. The outer circuit is electrically connected to the inner circuit. The protection layer is formed on the first surface of the substrate. The protection layer has an opening where the inner circuit is disposed. The semiconductor die has an active surface, a plurality of bond pads formed on the active surface, and a back surface opposite to the active surface. The semiconductor die is mounted in the opening of the protection layer such that the plurality of bond pads contact the inner circuit, and a gap exist between the semiconductor die and the protection layer. The heat-dissipating module includes a heat-conducting device which has a flat end surface at a distal end thereof. The heat-conducting device, via the distal end of the heat-conducting device, is inserted into the opening of the protection layer, and the flat end surface thereof contacts and bonds with the back surface of the semiconductor die.

According to the second preferred embodiment of the invention, the method of making the IC packing structure is to prepare a substrate and a semiconductor. The substrate has a first surface, an inner circuit formed on the first surface, a second surface opposite to the first surface, and an outer circuit formed on the second surface. The outer circuit is electrically connected to the inner circuit. The semiconductor has an active surface, a plurality of bond pads formed on the active surface, and a back surface opposite to the active surface.

The method is, first, to form a protection layer. The protection layer contacts a portion of the first surface of the substrate, which has an opening where the inner circuit is disposed. Then, the semiconductor die is mounted in the opening of the protection layer such that the plurality of bond pads contact the inner circuit, and a gap exists between the semiconductor die and the protection layer. The distal end of the heat-dissipating module is further disposed into the opening of the protection layer. The heat-dissipating module includes a heat-conducting device which has a flat end surface at a distal thereof. Finally, the flat end surface of the heat-conducting device contacts and bonds with the back surface of the semiconductor die to complete the IC packing structure.

Because the IC packing structure of the invention bonds the heat-dissipating module with the semiconductor die, the heat-conducting device directly conducts the heat produced by the semiconductor die to the surrounding air via the fins. This not only solves the hot spot issue, but also greatly improves the heat-dissipating efficiency. The IC packing structure further integrates other heat-dissipating techniques to achieve a better effect of heat dissipating. Therefore, comparing with the prior art, the IC packing structure of the invention is more suitable for the application of high power semiconductor devices.

The advantage and spirit of the invention may be understood by the following recitations together with the appended drawings.

### BRIEF DESCRIPTION OF THE APPENDED DRAWINGS

FIG. 1A and FIG. 1B illustrate the IC packing structure of current integrated heat-dissipating devices.
FIG. 2 illustrates an outward view of the IC packing structure of the present invention.
FIG. 3 is a cross-sectional diagram along the A-A line in FIG. 2, illustrating the IC packing structure of the first embodiment of the present invention.
FIGS. 4A through 4D illustrate the process of the IC packing structure according to the first preferred embodiment of the present invention.
FIG. 5 is a cross-sectional diagram along the A-A line in FIG. 2, illustrating the IC packing structure of the second embodiment of the present invention.
FIGS. 6A through 6E illustrate the process of the IC packing structure according to the second preferred embodiment of the present invention.
FIG. 7 illustrates the heat dissipating mechanism of the heat-dissipating module.

### DETAILED DESCRIPTION OF THE INVENTION

A scope of the present invention provides an IC packing structure.

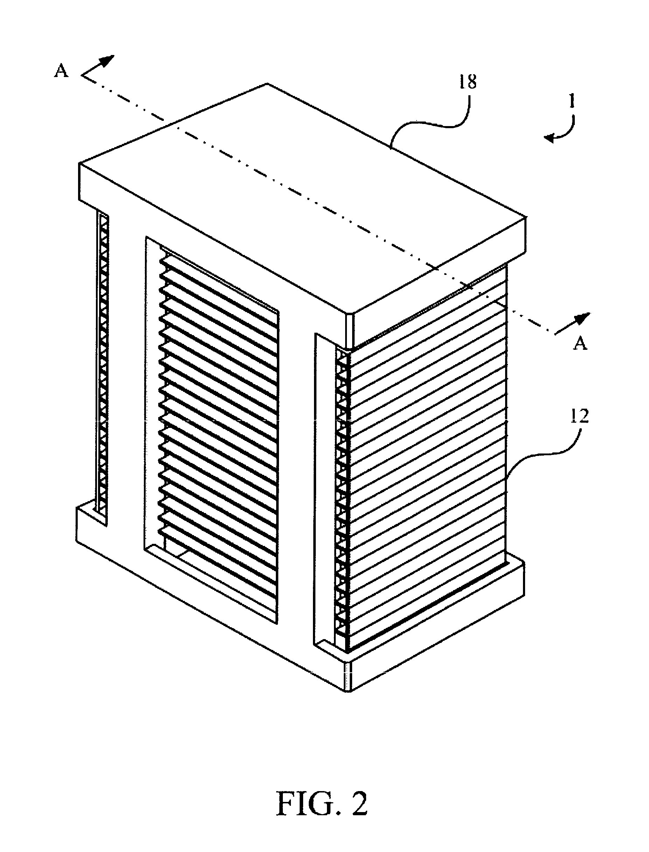

Referring to FIG. 2, FIG. 2 illustrates an outward view of the IC packing structure of the invention. As shown in FIG. 2, the IC packing structure 1 includes a heat-dissipating module 12 and a casing 18.

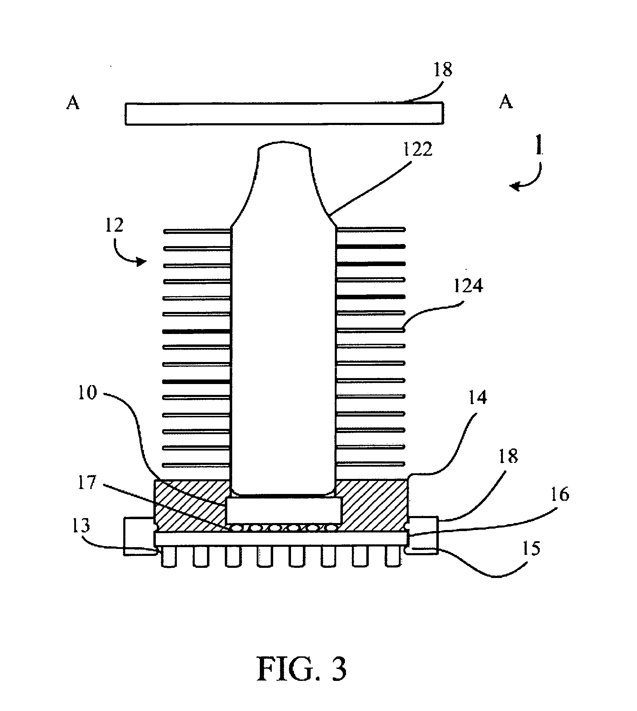

Referring to FIG. 3, FIG. 3, a cross-sectional diagram along the A-A line in FIG. 2, illustrates a first preferred embodiment according to the IC packing structure of the invention. As shown in FIG. 3, according to the first preferred embodiment of the invention, the IC packing structure 1 further comprises a semiconductor die 10, a substrate 16, and a protection layer 14. In the first preferred embodiment, the semiconductor die can be a high power semiconductor device.

The substrate 16 has a first surface, an inner circuit formed on the first surface, a second surface opposite to the first surface, and an outer circuit 13 formed on the second surface. The outer circuit 13 is electrically connected to the inner circuit. The semiconductor 10 has an active surface, a plurality of bond pads 17 formed on the active surface, and a back surface opposite to the active surface. The semiconductor die 10 is mounted on the first surface of the substrate 16 by a flip-chip process, such that the plurality of bond pads 17 contact and are electrically connected to the inner circuit.

The heat-dissipating module 12 includes a heat-conducting device 122 and a plurality of heat-dissipating fins 124. The heat-conducting device 122 can be a heat pipe, a heat column, or a column made of a material with high thermal conductivity. The heat-conducting device 122 has a flat end, and the heat-dissipating fins 124 are disposed around its circumference to enhance heat dissipating. The heat-conducting device 122, via the flat end surface thereof, contacts and bonds with the back surface of the semiconductor die 10. The protection layer 14 contacts a portion of the first surface of the substrate 16 and a portion of the heat-conducting device 122, such that the semiconductor die 10 is encapsulated therebetween. The casing 18 is capable of enclosing the heat-dissipating module 12, the protection layer 14, and the substrate 16. In practical application, other heat-dissipating devices can be configured on the top surface of the casing, or a fan can be configured on a side of the IC packing structure 1.

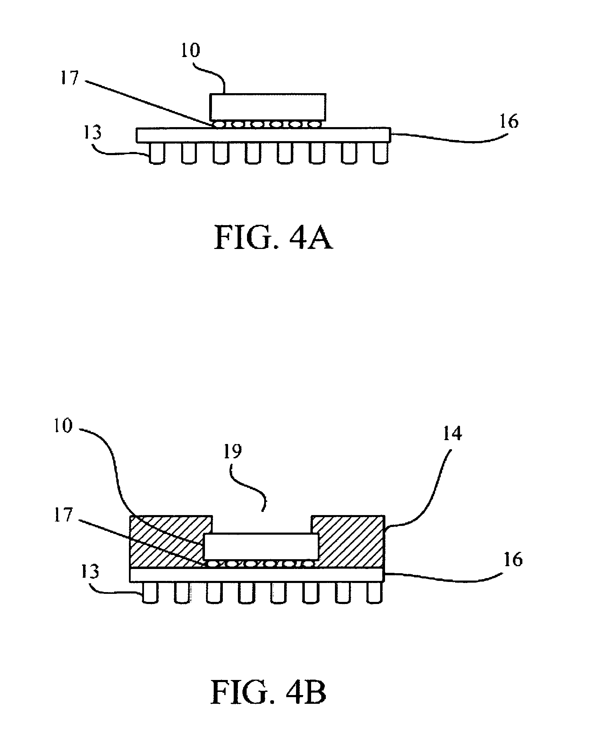

According to the first preferred embodiment of the IC packing structure of the invention, the method of making the IC packing structure will be described in detail as follows. Referring to FIGS. 4A through 4D, FIGS. 4A through 4D illustrate the process of the IC packing structure according to the first preferred embodiment of the invention.

First, a substrate 16 and a semiconductor die 10 are prepared. The substrate 16 has a first surface, an inner circuit formed on the first surface, a second surface opposite to the first surface, and an outer circuit 13 formed on the second surface. The outer circuit 13 is electrically connected to the inner circuit. The semiconductor die 10 has an active surface, a plurality of bond pads 17 on the active surface, and a back surface opposite to the active surface. The heat-dissipating module 12 includes a heat-conducting device 122 which has a flat end surface at a distal thereof.

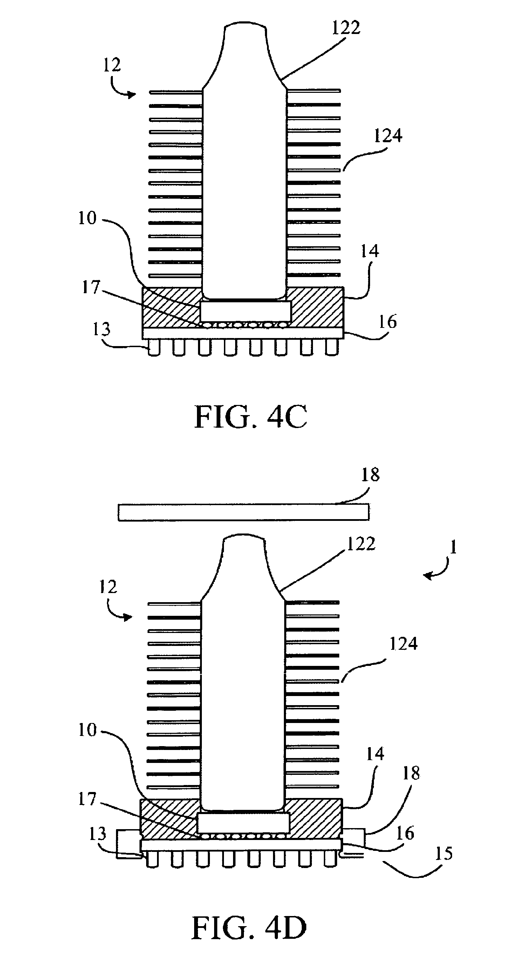

Referring to FIG. 4A, as shown in FIG. 4A, the semiconductor die 10 is mounted on the first surface of the substrate 16 by a flip-chip process, such that the plurality of bond pads 17 contact the inner circuit on the substrate 16. Then, as shown in FIG. 4B, a protection layer 14 is formed to cover a portion of the substrate 10. Moreover, the protection layer 14 has an opening 19 adapted to accommodate the flat end surface of the heat-conducting device 122. As shown in FIG. 4C, the distal end of the heat-conducting device 122 is disposed into the opening 19, and the flat end surface of the heat-conducting device 122 contacts and bonds with the back surface of the semiconductor die 10. The heat-dissipating module 12 further includes a plurality of heat-dissipating fins 124, which are disposed around the circumference of the heat-conducting device 122 to assist heat dissipating. Finally, as shown in FIG. 4D, a casing 18 encloses the heat-dissipating module 12, the protection layer 14, and the substrate 16 to complete the IC packing structure 1.

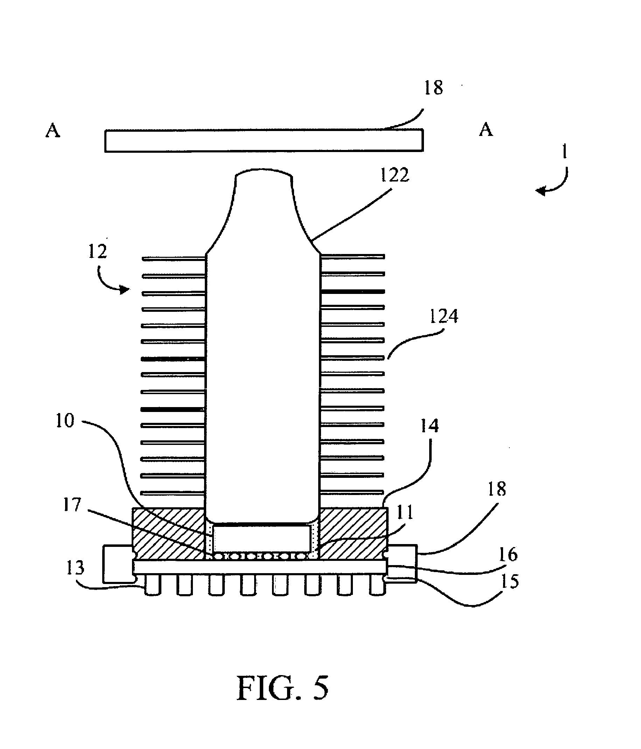

Referring to FIG. 5, FIG. 5, a cross-sectional diagram along the A-A line in FIG. 2, illustrates the IC packing structure according to a second preferred embodiment of the invention. As shown in FIG. 5, according to the second preferred embodiment of the invention, the IC packing structure 1 further includes a semiconductor die 10, a substrate 16, and a protection 14. In the second preferred embodiment, the semiconductor die can be a high power semiconductor device.

The substrate 16 has a first surface, an inner circuit formed on the first surface, a second surface opposite to the first surface, an outer circuit 13 formed on the second surface. The outer circuit 13 is electrically connected to the inner circuit. The protection layer 14 is formed on the first surface of the substrate 16. The protection layer 14 has an opening of which the area is substantially equal to that of the end surface of the heat-dissipating module. The inner circuit is disposed and exposed in the opening. The semiconductor 10 has an active surface, a plurality of bond pads 17 formed on the active surface, and a back surface opposite to the active surface. The semiconductor die 10 is mounted in the opening of the protection layer 14 by a flip-chip process, such that the plurality of bond pads 17 contact the inner circuit on the first surface of the substrate 16. Since the area of the end surface of the heat-dissipating module 12 is larger than that of the back surface of the semiconductor die 10, a gap 11 exists between the semiconductor die 10 and the protection layer 14. Thermal adhesive is used to fill up the gap 11 between the semiconductor die 10 and the protection layer 14 to enhance heat dissipating. The heat-dissipating module 12 includes a heat-conducting device 122 and a plurality of heat-dissipating fins 124. The heat-conducting device 122 has a flat surface at a distal end thereof. The heat-conducting device 122, via the distal end thereof, is inserted into the opening of the protection layer 14, and the flat end surface thereof contacts and bonds with the back surface of the semiconductor die 10. The heat-dissipating fins 124 are disposed around the circumference of the heat-conducting device 122 to enhance heat dissipating. The casing 18 is capable of enclosing the heat-dissipating module 12, the protection layer 14, and the substrate 16.

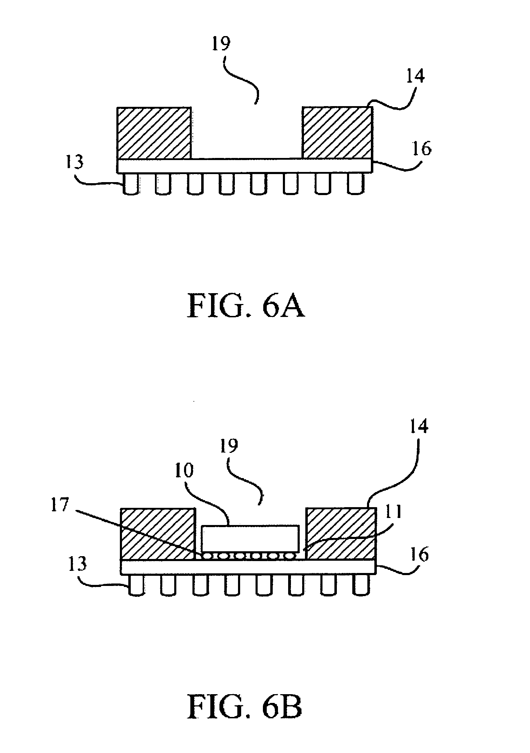

According to the second preferred embodiment of the IC packing structure of the invention, the method of making the IC packing structure will be described in detail as follows. Referring to FIGS. 6A through 6E, FIGS. 6A through 6E illustrate the process of the IC packing structure according to the second preferred embodiment of the invention.

First, a substrate 16 and a semiconductor die 10 are prepared. The substrate 16 has a first surface, an inner circuit formed on the first surface, a second surface opposite to the first surface, and an outer circuit 13 formed on the second surface. The outer circuit 13 is electrically connected to the inner circuit. The semiconductor die 10 has an active surface, a plurality of bond pads 17 formed on the active surface, and a back surface opposite to the active surface.

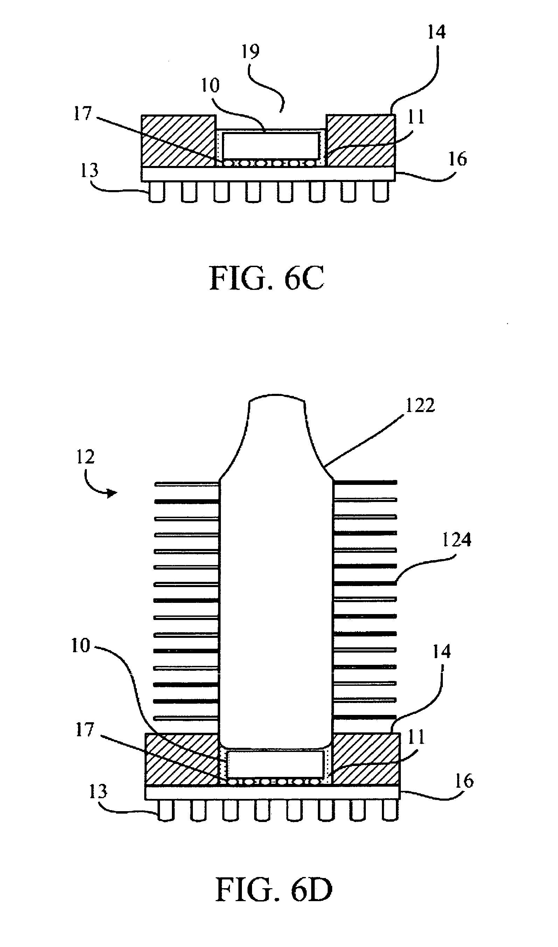

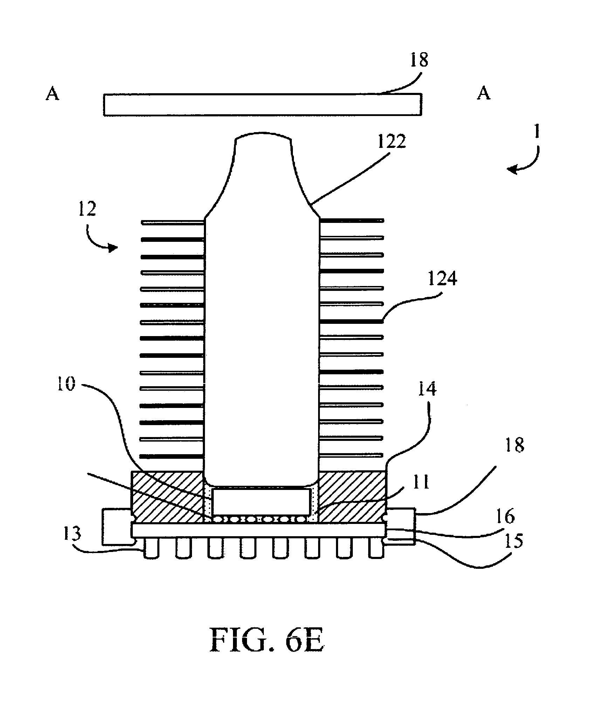

Referring to FIG. 6A, as shown in FIG. 6A, the method is, first, to form a protection layer 14 on the substrate 16. The protection layer 14 substantially covers the first surface of the substrate 16 and has an opening 19, of which the area is substantially equal to that of the end surface of the heat-dissipating module 12. The inner circuit is disposed and exposed in the opening 19. As shown in FIG. 6B, the semiconductor die 10 is mounted into the opening 19 of the protection layer 14 by a flip-chip process, such that the plurality of bond pads 17 contact the inner circuit on the substrate 16. Since the area of the opening 19 is larger than that of the back surface of the semiconductor die 10, a gap 11 exists between the semiconductor die 10 and the protection layer 14. Referring to FIG. 6C, as shown in FIG. 6C, thermal adhesive is used to fill up the gap 11 to enhance heat dissipating. As shown in FIG. 6D, the heat-dissipating module 12, via the distal end thereof, is inserted into the opening of the protection layer 14. The heat-dissipating module 12 includes a heat-conducting device 122 and a plurality of heat-dissipating fins 124. The heat-conducting device 122 has a flat end surface at a distal thereof. The heat-dissipating fins 124 are disposed around the circumference of the heat-conducting device 122 to enhance heat dissipating. The heat-conducting device 122 contacts and bonds the flat end surface thereof with the back surface of the semiconductor die 10. Finally, as shown in FIG. 6E, a casing 18 encloses the heat-dissipating module 12, the protection layer 14, and the substrate 16 to complete the IC packing structure 1. The casing has a top surface for heat conducting, which can be configured with other heat-dissipating devices to enhance the heat-dissipating effect.

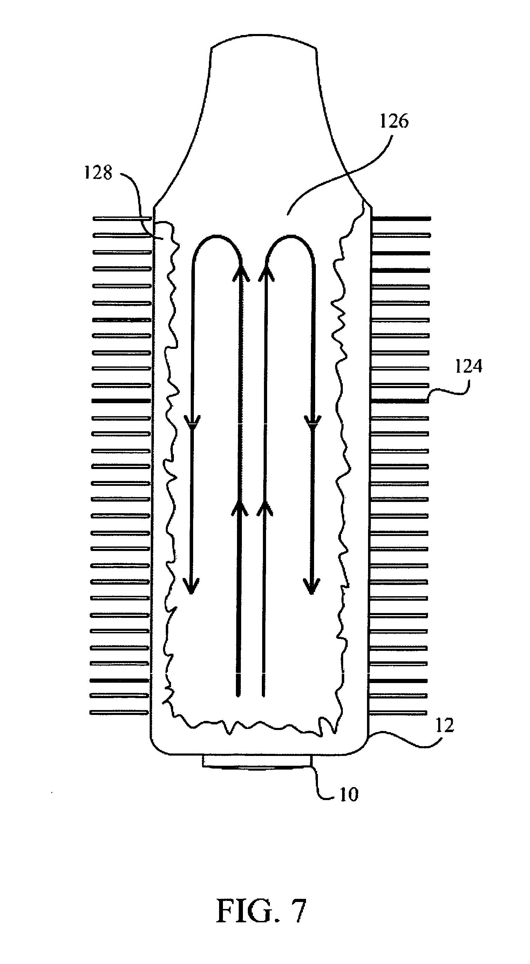

Referring to FIG. 7, FIG. 7 illustrates the heat dissipating mechanism of the heat-dissipating module. As shown in FIG. 7, the heat-dissipating module 12 includes the heat-conducting device 122 and a plurality of heat-dissipating fins 124. In practical application, the heat-conducting device 122 can be a heat column or a heat pipe made of copper. The heat-conducting device 122 includes a working fluid 126 and a capillary structure 128. The heat-dissipating fins 124 are disposed around the circumference of the heat-dissipating device 122 to enhance heat dissipating. When heat is produced by the semiconductor die 10, the working fluid 126 near the semiconductor die 10 in the heat-conducting device 122 vaporizes from liquid phase to vapor phase. The evaporated working fluid 126 transmits the heat to the other end of the heat-conducting device 122. The working fluid 126 will condense to liquid phase after the heat is dissipated through the heat-dissipating fins 124. The capillary structure 128 transmits the condensed working fluid 126 to the zone near the semiconductor die 10 in the heat-conducting device 122. The heat-conducting and heat-dissipating effect will be achieved by circulation, as shown in FIG. 7.

Because the IC packing structure of the invention bonds the heat-dissipating module with the semiconductor die, the heat-dissipating module directly dissipates the heat produced by the semiconductor die to the surrounding air via heat-dissipating fins and thermal adhesive, which greatly improves the heat-dissipating efficiency. The improvement of the heat-dissipating efficiency of semiconductor devices solves the issue of performance reduction of the semiconductor devices due to overheating. Therefore, comparing with the prior art, the IC packing structure of the invention is more suitable to the application of high power semiconductor devices.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. An integrated circuit packaging structure, comprising:
a substrate having a first surface, an inner circuit formed on the first surface, a second surface opposite to the first surface, and an outer circuit formed on the second surface and electrically connected to the inner circuit;
a semiconductor die having an active surface, a plurality of bond pads formed on the active surface, and a back surface opposite to the active surface, the semiconductor die being mounted on the first surface of the substrate such that the plurality of bond pads contact the inner circuit;
a heat-dissipating module comprising a heat-conducting device having a flat end surface, the heat-conducting device via the flat end surface thereof contacting and bonding with the back surface of the semiconductor die; and
a protection layer formed to contact a portion of the first surface of the substrate and a portion of the heat-conducting device, such that the semiconductor die is encapsulated therebetween.

2. The integrated circuit packaging structure of claim 1, further comprising a casing for enclosing the heat-dissipating module, the protection layer, and the substrate.

3. The integrated circuit packaging structure of claim 2, wherein the casing has an opening and a retainer formed on the inner wall of the opening for clamping with the substrate.

4. The integrated circuit packaging structure of claim 1, wherein the heat-dissipating module further comprises at least one heat-dissipating fin disposed around a circumference of the heat-conducting device.

5. The integrated circuit packaging structure of claim 1, wherein the heat-conducting device is a heat pipe, a heat column, or a column made of a material with high thermal conductivity.

6. The integrated circuit packaging structure of claim 1, wherein the semiconductor die is a high power IC device.

7. The integrated circuit packaging structure of claim 1, wherein the semiconductor die is mounted on the first surface of the substrate by a flip-chip process.

8. A method of making an integrated circuit packaging structure, said method comprising the steps of:
preparing a substrate having a first surface, an inner circuit formed on the first surface, a second surface opposite to the first surface, and an outer circuit formed on the second surface and electrically connected to the inner circuit;
preparing a semiconductor die having an active surface and a plurality of bond pads formed on the active surface, and mounting the semiconductor die on the first surface of the substrate such that the plurality of bond pads contact the inner circuit, wherein the semiconductor die also has a back surface opposite to the active surface;
preparing a heat-dissipating module comprising a heat-conducting device having a flat end surface at a distal end thereof;
forming a protection layer to substantially cover a portion of the first surface of the substrate, the protection layer having an opening adapted to accommodate the flat end surface of the heat-conducting device; and
disposing the distal end of the heat-conducting device into the opening of the protection layer, and contacting and bonding the flat end surface of the heat-conducting device with the back surface of the semiconductor die to complete the integrated circuit packaging.

9. The method of claim 8, further comprising the step of:
by a casing, enclosing the heat-dissipating module, the protection layer, and the substrate.

10. The method of claim 8, wherein the casing has an opening and a retainer formed on the inner wall of the opening of the casing for clamping the substrate.

11. The method of claim 8, wherein the heat-dissipating module further comprises at least one heat-dissipating fin disposed around a circumference of the heat-conducting device.

12. The method of claim 8, wherein the heat-conducting device is a heat pipe, a heat column, or a column made of a material with high thermal conductivity.

13. The method of claim 8, wherein the semiconductor die is a high power IC device.

14. The method of claim 8, wherein the semiconductor die is mounted on the first surface of the substrate by a flip-chip process.

15. An integrated circuit packaging structure, comprising:
a substrate having a first surface, an inner circuit formed on the first surface, a second surface opposite to the first surface, and an outer circuit formed on the second surface and electrically connected to the inner circuit;
a protection layer formed on the first surface of the substrate, the protection layer having an opening where the inner circuit is disposed;
a semiconductor die having an active surface, a plurality of bond pads formed on the active surface, and a back surface opposite to the active surface, the semiconductor die being mounted in the opening of the protection layer such that the plurality of bond pads contact the inner circuit, and a gap exists between the semiconductor die and the protection layer; and
a heat-dissipating module comprising a heat-conducting device having a flat end surface at a distal end thereof, the heat-conducting device via the distal end thereof inserting into the opening of the protection layer and via the flat end surface thereof contacting and bonding with the back surface of the semiconductor die.

16. The integrated circuit packaging structure of claim 15, wherein the gap between the semiconductor die and the protection layer is filled with a thermal adhesive.

17. The integrated circuit packaging structure of claim 15, further comprising a casing for enclosing the heat-dissipating module, the protection layer, and the substrate.

18. The integrated circuit packaging structure of claim 17, wherein the casing has an opening and a retainer formed on the inner wall of the opening of the casing for clamping the substrate.

19. The integrated circuit packaging structure of claim 15, wherein the heat-dissipating module further comprises at least one heat-dissipating fin disposed around a circumference of the heat-conducting device.

20. The integrated circuit packaging structure of claim 15, wherein the heat-conducting device is a heat pipe, a heat column, or a column made of a material with high thermal conductivity.

21. The integrated circuit packaging structure of claim 15, wherein the semiconductor die is a high power IC device.

22. The integrated circuit packaging structure of claim 15, wherein the semiconductor die is mounted on the first surface of the substrate by a flip-chip process.

23. A method of making an integrated circuit packaging structure, said method comprising the steps of:
preparing a substrate having a first surface, an inner circuit formed on the first surface, a second surface opposite to the first surface, and an outer circuit formed on the second surface and electrically connected to the inner circuit;
forming a protection layer to contact the first surface of the substrate, the protection layer having an opening where the inner circuit is disposed;
preparing a semiconductor die having an active surface and a plurality of bond pads formed on the active surface, and mounting the semiconductor die in the opening of the protection layer such that the plurality of bond pads contact the inner circuit, and a gap exists between the semiconductor die and the protection layer, wherein the semiconductor also has a back surface opposite to the active surface;
preparing a heat-dissipating module comprising a heat-conducting device having a flat end surface at a distal end thereof, and disposing the distal
' end of the heat-conducting device into the opening of the protection layer; and
contacting and bonding the flat end surface of the heat-conducting device with the back surface of the semiconductor die to complete the integrated circuit packaging.

24. The method of claim 23, further comprising the step of:
filling a thermal adhesive into the gap between the semiconductor die and the protection layer.

25. The method of claim 23, further comprising the step of:
by a casing, enclosing the heat-dissipating module, the protection layer, and the substrate.

26. The method of claim 25, wherein the casing has an opening and a retainer formed on the inner wall of the opening of the casing for clamping the substrate.

27. The method of claim 23, wherein the heat-dissipating module comprises at least one heat-dissipating fin disposed around a circumference of the heat-conducting device.

28. The method of claim 23, wherein the heat-conducting device is a heat pipe, a heat column, or a column made of a material with high thermal conductivity.

29. The method of claim 23, wherein the semiconductor die is a high power IC device.

30. The method of claim 23, wherein the semiconductor die is mounted on the first surface of the substrate by a flip-chip process.
